# EUROPÄISCHE PATENTSCHRIFT

(11) **EP 1 055 285 B1**
(45) Veröffentlichungstag und Bekanntmachung des Hinweises auf die Patenterteilung: **09.10.2002**
(21) Anmeldenummer: 99913068.5
(22) Anmeldetag: 05.02.1999
(51) Int. Cl.: H03H 9/05, H03H 9/10, H03H 9/25

(54) **VERFAHREN ZUR HERSTELLUNG EINES ELEKTRONISCHEN BAUELEMENTS, INSBESONDERE EINES MIT AKUSTISCHEN OBERFLÄCHENWELLEN ARBEITENDEN OFW-BAUELEMENTS**
PROCESS FOR MANUFACTURING AN ELECTRONIC COMPONENT, IN PARTICULAR A SURFACE-WAVE COMPONENT WORKING WITH ACOUSTIC SURFACE WAVES
PROCEDE DE PRODUCTION D'UN COMPOSANT ELECTRONIQUE, EN PARTICULIER D'UN COMPOSANT A ONDES DE SURFACE FONCTIONNANT AVEC DES ONDES DE SURFACE ACOUSTIQUES

(30) Priorität: 18.02.1998 DE 19806818
(43) Veröffentlichungstag der Anmeldung: 29.11.2000
(73) Patentinhaber: EPCOS AG, 81541 München (DE)
(72) Erfinder: STELZL, Alois, D-81549 München (DE); KRÜGER, Hans, D-81737 München (DE); DEMMER, Peter, D-81479 München (DE)
(74) Vertreter: Epping, Wilhelm, Dipl.-Ing.
(86) Internationale Anmeldenummer: DE9900307
(87) Internationale Veröffentlichungsnummer: WO99043084

(56) Entgegenhaltungen:
- EP-A- 0 637 871
- EP-A- 0 794 616
- EP-A- 0 840 369
- WO-A-97/45955
- DE-A- 3 138 743
- US-A- 5 410 789
- US-A- 5 540 870
- PATENT ABSTRACTS OF JAPAN vol. 097, no. 005, 30. Mai 1997 (1997-05-30) -& JP 09 008596 A (KOKUSAI ELECTRIC CO LTD), 10. Januar 1997 (1997-01-10)

## Beschreibung

Die Erfindung betrifft ein Verfahren zur Herstellung eines elektronischen Bauelements, insbesondere eines OFW Bauelements, bei dem eine in Basisplatten vereinzelbare Trägerplatte jeweils in Basisplatten-Bereichen mit Leiterbahnen versehen wird, je Basisplatten-Bereich ein Chip mit einem piezoelektrischen Substrat und aktiven Filterstrukturen, die mit den Leiterbahnen kontaktiert werden, eine Deckfolie auf die Chip-bestückte Trägerplatte aufgebracht wird, die Deckfolie so behandelt wird, so daß sie jeden Chip mit Ausnahme der zur Trägerplatte gekehrten Chip-Fläche umhüllt und in Bereichen zwischen den Chips auf der Trägerplatten-Fläche aufliegt und die Trägerplatte in die einzelnen Bauelemente aufgetrennt wird.

Ein solches Bauelement ist beispielsweise aus der WO-A-9702596 bekannt.

Zum Schutz gegen störende Umwelteinflüsse, insbesondere gegen chemisch aggressive Substanzen und Feuchtigkeit, ist es beispielsweise aus der WO-A-97/45955 bekannt, bei in Flip-Chip-Technik, d.h. mittels Bumps bzw. Lotkugeln mit den Leiterbahnen der Keramik- oder Kunststoff-Basisplatte kontaktierten aktiven Filterstrukturen zwischen Basisplatte und Chip eine gegebenenfalls mehrlagige, üblicherweise 2-lagige, strukturierte Schutzfolie, anmelderseits PROTEC genannt, anzuordnen. Geschützt durch diese Folie kann das OFW-Filter nach dem Flip-Chip-Bonden mit Vergußmasse, z.B. Epoxidharz, unterfüllt und umgossen werden, ohne daß dabei die aktive Filterstruktur beschichtet und damit die Oberflächenwellen unzulässig gedämpft werden.

Es hat sich gezeigt, daß bei in Flip-Chip-Technik kontaktierten OFW-Filtern höchstfrequenten Durchlaßbereichs, d.h. typischerweise bei Chip-Abmessungen kleiner etwa 2 x 2 mm², trotz Nichtunterfüllung der entsprechenden Räume zwischen Basisplatte und Chip eine ausreichende Stabilität bei Temperaturwechselbelastung gegeben ist.

Veranlaßt durch diese Erkenntnis hat sich die Erfindung die Aufgabe gestellt, ein Verfahren anzugeben, das einen Verzicht auf die teuere PROTEC-Kapselung der OFW-Bauelemente ermöglicht und trotzdem ausgezeichnete OFW-Bauelemente schafft.

Zur Lösung dieser Aufgabe sieht die Erfindung bei einem Verfahren der eingangs genannten Art vor, die Chips mit der Basisplatte in Flip-Chip-Technik zu kontaktieren und als Deckfolie eine Kunststoff-Folie aus einem Klebermaterial im B-Zustand zu verwenden, die nach dem Aufbringen auf den Chip druck- und wärmebehandelt wird.

Weiterbildungen der Erfindung sind den Unteransprüchen und der Zeichnung samt Beschreibung entnehmbar. Es zeigt:
- Fig. 1:: in teils gebrochener Darstellung eine Draufsicht auf eine erfindungsgemäß verwendete Trägerplatte;
- Fig. 2:: in teils geschnittener und gebrochener Darstellung eine Seitenansicht eines ersten Ausführungsbeispieles einer gemäß dem Verfahren nach der Erfindung Chip-bestückten Trägerplatte; und
- Fig. 3:: ein zweites Ausführungsbeispiel eines gemäß dem Verfahren nach der Erfindung gefertigten OFW-Filters gleichfalls in teils geschnittener Seitenansicht.

Gleiche Teile sind dabei mit gleichen Bezugszeichen bezeichnet.

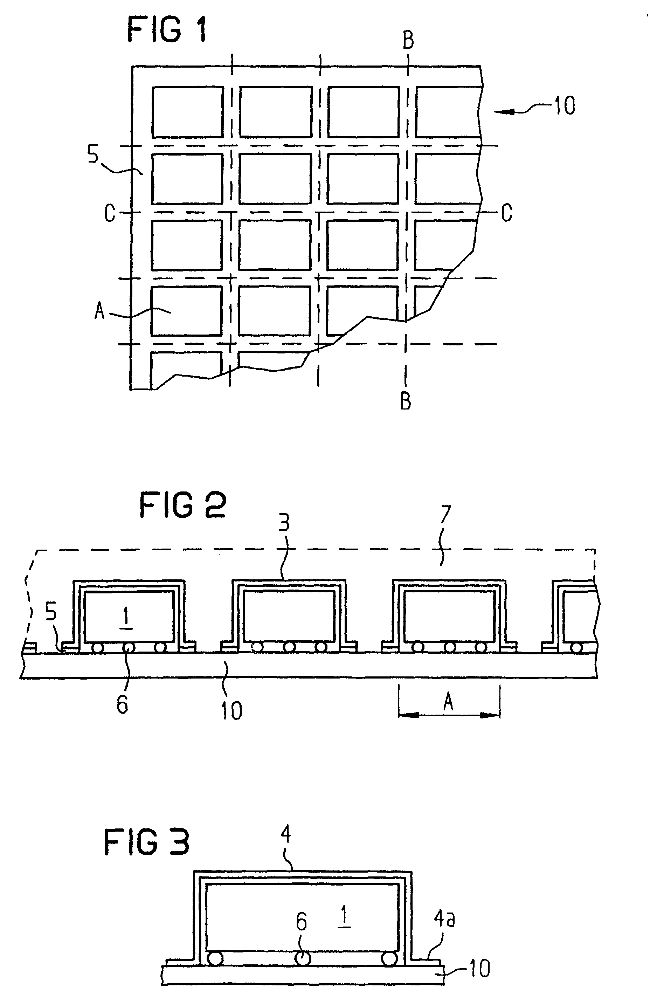

Beim ersterwähnten Verfahren wird eine längs den Trennlinien B-B' und C-C' in Basisplatten 2 - s. Fig. 3 - vereinzelbare Trägerplatte 10, z.B. eine Keramik- oder Kunststoffplatte, jeweils in den Basisplatten-Bereichen A mit in der Zeichnung nicht dargestellten Leiterbahnen versehen, die üblicherweise zum rückseitigen Basisplatten-Bereich durchkontaktiert sind. Bevorzugt gleichzeitig mit dem Aufbringen der Leiterbahnen wird dabei die Trägerplatte 10 entsprechend den Basisplatten-Abmessungen mit einem lötfähigen Metallraster 5 beschichtet und nachfolgend je Basisplatten-Bereich A ein Chip 1 mittels Bumps 6 mit dessen Leiterbahnen in Flip-Chip-Technik kontaktiert.

Auf die Chip-bestückte Trägerplatte 10 wird schließlich eine Deckfolie - nämlich eine Metallfolie 3 geeigneter Dicke und Duktibilität - aufgebracht und z.B. in einem Autoklaven oder unter Vakuum druck- und wärmebehandelt derart, daß sie jedes Chip 1 dicht umhüllt - ausgenommen die zur Trägerplatte 10 benachbarte Chip-Fläche -, in den Bereichen zwischen den Chips 1 auf dem Metallraster 9 aufliegt und mit diesem längs des lötfähigen Metallrahmens verlötet ist.

Durch diese Art der Behandlung der Metallfolie 3 so auch durch Ultraschall-Beaufschlagung längs des Metallrasters 5 schmiegt sich die Metallfolie 3 an jedes Chip 1 quasi als kappenförmiges Gehäuse an, das mit seinen Stirnrändern 3a hermetisch dicht auf dem Metallrahmen 5 bzw. auf der Trägerplatte 10 aufsitzt.

Vorausgesetzt es wird kein hermetisch dichter Verschluß zwischen Folie und Basisplatte benötigt, so kann anstelle der Metallfolie 3 eine gegebenenfalls zur elektromagnetischen Abschirmung metallbeschichtete Kunststoff-Folie 4 - s. Fig. 3 - verwendet werden, die z.B. aus einem Klebermaterial im B-Zustand besteht oder auf ihrer zur Trägerplatte 10 gekehrten Oberfläche kleberbeschichtet ist. Auch diese Folie, die wiederum einer Druck- und Wärmebehandlung in einem Autoklaven unterzogen werden kann, umschließt den Chip hermetisch dicht. Allerdings sitzt, da sich bei Kunststoff-Folien ein Metallraster 5 erübrigt, der Stirnrand 4a jedes "Kunststoff-Gehäuses" unmittelbar auf der Trägerplatte 10 bzw. auf der Basisplatte 2 auf.

Es erweist sich auch als geeignet, die Metall- oder Kunststoff-Folie 3 bzw. 4 vorab in einem durch die Basisplatten 2 bestimmten Rastermaß kappenförmig tief zu ziehen und diese teils tiefgezogene Folie über die Chip-bestückte Trägerplatte 10 zu stülpen, wonach sie in vorgenannter Weise mit ihren auf der Trägerplatte 10 aufliegenden Bereichen 3a bzw. 4a mit der Trägerplatte dicht verbunden wird. Diese Möglichkeit ist insbesondere für schrumpffreie oder schrumpfarme Trägerplatten von großer Bedeutung.

Die so entstandenen Gehäuse in Nutzentechnik können, wie dies in Fig. 2 strichliniert (s. Bereich 7) angedeutet ist, durch Umpressen oder Vergießen, z.B. mit Epoxidharz, weiter stabilisiert und zusätzlich hermetisch dicht mit einem Metallmantel abgedichtet werden.

Auf die Außen- und/oder Innenfläche der Metall- und Kunststoff-Folie 3 bzw. 4 können ferner partiell Schichtfolgen, bestehend aus Dämpfungsmasse, aufgebracht werden, die so abgestimmt werden, daß sie gegebenenfalls im Zusammenwirken mit einer Umpreß- oder Vergußmasse 7 störende akustische Volumenwellen dämpfen.

Als Dämpfungsmasse eignen sich insbesondere gefüllte Epoxidharze, z.B. mit SiO₂, W, WO₃ oder Ag als Füllkomponente.

## Patentansprüche

1. Verfahren zur Herstellung eines elektronischen Bauelements, insbesondere eines OFW Bauelements, bei dem
eine in Basisplatten (2) vereinzelbare Trägerplatte (10) jeweils in Basisplatten-Bereichen (A) mit Leiterbahnen versehen wird,
je Basisplatten-Bereich (A) ein Chip (1) mit einem piezoelektrischen Substrat und aktiven Filterstrukturen, die mit den Leiterbahnen der Basisplatte in Flip-Chip-Technik kontaktiert werden,
eine Deckfolie auf die Chip-bestückte Trägerplatte (10) aufgebracht wird,
die Deckfolie so behandelt wird, so daß sie jeden Chip (1) mit Ausnahme der zur Trägerplatte (10) gekehrten Chip-Fläche umhüllt und in Bereichen zwischen den Chips (1) auf der Trägerplatten-Fläche aufliegt und
die Trägerplatte (10) in die einzelnen OFW-Bauelemente (1, 2) aufgetrennt wird,
**dadurch gekennzeichnet, daß**
daß als Deckfolie eine Kunststoff-Folie (4) aus einem Klebermaterial im B-Zustand verwendet wird, die nach dem Aufbringen auf den Chip druck- und wärmebehandelt wird.

2. Verfahren nach Anspruch 1,
bei dem die Deckfolie (4) metallbeschichtet ist.

3. Verfahren nach Anspruch 1 oder 2,
bei dem die Deckfolie (4) auf ihrer zur Trägerplatte (10) gekehrten Oberfläche kleberbeschichtet ist.

4. Verfahren nach einem der Ansprüche 1 bis 3,
bei dem die Deckfolie vorab in einem durch die Basisplatten (2) bestimmten Rastermaß kappenförmig tiefgezogen, über die Chip-bestückte Trägerplatte (10) gestülpt und mit ihren auf der Trägerplatte (10) aufliegenden Bereichen mit der Trägerplatte (10) verbunden wird.

5. Verfahren nach einem der Ansprüche 1 bis 4,
bei dem die Deckfolie (4) durch Druck- und Wärmebehandlung auf die Chips (1) und die Trägerplatte (10) aufgebracht wird.

6. Verfahren nach Anspruch 5,
bei dem die Druck- und Wärmebehandlung unter Vakuum erfolgt.

7. Verfahren nach einem der Ansprüche 1 bis 6,
bei dem als Trägerplatte (10) eine Keramik- oder Kunststoffplatte verwendet wird.

8. Verfahren nach Anspruch 7,
bei dem als Trägerplatte (10) eine durchkontaktierte, beiderseits mit Leiterbahnen beschichtete Keramik- oder Kunststoffplatte verwendet wird.

9. Verfahren nach einem der Ansprüche 1 bis 8,
bei dem die Deckfolie nach Umhüllung der Chips (1) mit Kunststoff (7) umpreßt oder umgossen wird.

10. Verfahren nach einem der Ansprüche 1 bis 9,
bei dem auf die Außen- und/oder Innenfläche der Kunststoff-Folie (3; 4) partiell Schichtfolgen, bestehend aus Dämpfungsmasse aufgebracht werden, die abgestimmt werden, so daß sie gegebenenfalls im Zusammenwirken mit einer Umpreß- oder Vergußmasse (7) störende akustische Volumenwellen dämpfen.

11. Verfahren nach Anspruch 10,
bei dem als Dämpfungsmasse gefülltes Epoxidharz verwendet wird.

12. Verfahren nach Anspruch 11,
bei dem mit SiO₂, W, WO₃ oder Ag gefülltes Epoxidharz verwendet wird.

## Claims

1. Method for production of an electronic component, in particular of an SAW component, in which a mounting board (10) which can be separated into base boards (2) is provided with conductor tracks in each of the base board areas (A),
each base board area (A) [lacuna] a chip (1) with a piezoelectric substrate and active filter structures, which make contact with the conductor tracks on the base board using flip chip technology,
a covering film is applied to the mounting board (10), which is fitted with chips,
the covering film is treated such that it surrounds each chip (1) with the exception of the chip surface which faces the mounting board (10), and rests on the mounting board surface in areas between the chips (1), and
the mounting board (10) is separated into the individual SAW components (1, 2),
**characterized in that**
**in that** [sic] the covering film is a plastic film (4) composed of an adhesive material in the B state, which is pressure-treated and heat-treated after being fitted to the chip.

2. Method according to Claim 1,
in which the covering film (4) is coated with metal.

3. Method according to Claim 1 or 2,
in which the covering film (4) is coated with adhesive on its surface facing the mounting board (10).

4. Method according to Claims 1 to 3,
in which the covering film is thermoformed in the shape of a cap in advance using a grid size which is governed by the base boards (2), is placed over the mounting board (10) which has been fitted with chips, and is connected to the mounting board (10) by its areas which rest on the mounting board (10).

5. Method according one of Claims 1 to 4,
in which the covering film (4) is applied to the chips (1) and to the mounting board (10) by means of pressure treatment and heat treatment.

6. Method according to Claim 5,
in which the pressure treatment and heat treatment are carried out in a vacuum.

7. Method according to one of Claims 1 to 6,
in which a ceramic or plastic sheet is used as the mounting board (10).

8. Method according to Claim 7,
in which a plated-through ceramic or plastic sheet, which is coated with conductor tracks on both sides, is used as the mounting board (10).

9. Method according to one of Claims 1 to 8,
in which the covering film is encapsulated or extrusion-coated with plastic (7) after surrounding the chips (1).

10. Method according to one of Claims 1 to 9,
in which layer sequences, composed of a damping compound, are applied partially to the outer surface and/or inner surface of the plastic film (3; 4) and are matched such that, possibly interacting with an extrusion-coating or encapsulation compound (7), they damp disturbing acoustic volume waves.

11. Method according to Claim 10,
in which filled epoxy resin is used as the damping compound.

12. Method according to Claim 11,
in which epoxy resin filled with SiO₂, W, WO₃ or Ag is used.

## Revendications

1. Procédé de production d'un composant électronique, notamment d'un composant à ondes de surface, dans lequel une plaque (10) support pouvant être individualisée en des plaques (2) de base est munie respectivement, dans les parties (A) de plaques de base, de pistes conductrices,
chaque partie (A) de plaque de base a une puce (1) ayant un substrat piézoélectrique et des structures actives de filtrage qui sont mises en contact avec les pistes conductrices de la plaque de base suivant la technique flip-chip,
une feuille de finition est déposée sur la plaque (10) support munie de la puce,
la feuille de finition est traitée de manière à ce qu'elle entoure chaque puce (1), à l'exception de la face de la puce tournée vers la plaque (10) support, et de manière à s'appliquer dans les parties comprises entre les puces (1) sur la surface de la plaque support, et
la plaque (10) support est séparée en les composants (1, 2) à ondes de surface individuels,
**caractérisé en ce que** l'on utilise comme feuille de finition une feuille (4) en matière plastique en une matière adhésive à l'état (B), qui est traitée sous pression et par la chaleur après le dépôt sur la puce.

2. Procédé suivant la revendication 1, dans lequel la feuille (4) de finition est revêtue de métal.

3. Procédé suivant la revendication 1 ou 2, dans lequel la feuille (4) de finition est revêtue de colle sur sa surface tournée vers la plaque (10) support.

4. Procédé suivant l'une des revendications 1 à 3, dans lequel la feuille de finition subit au préalable un emboutissage profond en forme de capuchon suivant une trame déterminée par les plaques (2) de base, est retournée sur la plaque (10) support munie des puces et est reliée à la plaque (10) support par ses parties s'appliquant à la plaque (10) support.

5. Procédé suivant l'une des revendications 1 à 4, dans lequel la feuille (4) de finition est déposée par traitement sous pression et par la chaleur sur les puces (1) et sur la plaque (10) support.

6. Procédé suivant la revendication 5, dans lequel le traitement sous pression et par la chaleur s'effectue sous vide.

7. Procédé suivant l'une des revendications 1 à 6, dans lequel on utilise comme plaque (10) support une plaque en céramique ou une plaque en matière plastique.

8. Procédé suivant la revendication 7, dans lequel on utilise comme plaque (10) support une plaque en céramique ou en matière plastique à contact traversant et revêtue des deux côtés de pistes conductrices.

9. Procédé suivant l'une des revendications 1 à 8, dans lequel la feuille de finition est mise par enrobage ou par coulée après enrobage de la puce (1) par de la matière plastique (7).

10. Procédé suivant l'une des revendications 1 à 9, dans lequel on dépose sur la surface extérieure et/ou intérieure de la feuille (3 ; 4) en matière plastique partiellement des successions de couches constituées de composition d'amortissement, qui sont accordées de façon à ce qu'elles amortissent, le cas échéant en coopération avec une composition (7) d'enrobage ou de scellement, des ondes acoustiques volumiques parasites.

11. Procédé suivant la revendication 10, dans lequel on utilise comme composition d'amortissement une résine époxyde chargée.

12. Procédé suivant la revendication 11, dans lequel on utilise une résine époxyde chargée de SiO₂, W, WO₃ ou Ag.
